# EUROPEAN PATENT APPLICATION

(11) **EP 4 811 415 A1**
(43) Date of publication of application: **23.09.2026**
(21) Application number: 26165064.2
(22) Date of filing: 16.03.2026
(51) Int. Cl.: H01J 37/153

(54) **ABERRATION CORRECTION REFLECTOR APPARATUS, ABERRATION CORRECTION SYSTEM, AND METHOD THEREOF**

(30) Priority: 17.03.2025 CN 202510313899
(71) Applicant: Quantum Science Center of Guangdong-Hongkong- Macao Greater Bay Area, Shenzhen, Guangdong 518045 (CN)
(72) Inventor: WANG, Weishi, Guangdong, 518045 (CN)
(74) Representative: Isern Patentes y Marcas S.L.

(57) **Abstract**

The present application relates to the field of optics, and more particularly to an aberration correction reflector apparatus, an aberration correction system, and a method thereof. The aberration correction reflector apparatus includes a reflector and a transmission electrode group coaxially spaced from one side of the reflector, the transmission electrode group includes four or more transmission electrodes coaxially spaced apart. The reflector includes a reflector body, a first through hole for electrons to pass through is arranged at a center of the reflector body and passes through upper and lower surfaces of the reflector body, the reflector further includes a cover disposed on a side of the first through hole away from the transmission electrode group, the cover protrudes toward a direction away from the transmission electrode group. Each transmission electrode includes a transmission electrode body, and a second through hole for electrons to pass through is arranged at a center of the transmission electrode body and passes through upper and lower surfaces of the transmission electrode body. The correction system adopting the aberration correction reflector apparatus can simultaneously correct chromatic aberration, third-order spherical aberration, and fifth- order spherical aberration.

## Description

### TECHNICAL FIELD

The present application relates to the field of optics, and more particularly to an aberration correction reflector apparatus, an aberration correction system, and a method thereof.

### BACKGROUND

Over nearly one hundred years of development of electron-optical instruments, aberrations have consistently been a determining factor affecting the performance of such instruments. The reduction and elimination of aberrations therefore constitute a central issue in the design of electron-optical systems. Prior to the development of aberration correction technologies, control of aberrations was primarily achieved by increasing the symmetry of lenses and systems to reduce the number of aberrations and by optimizing the geometrical shape of lenses to reduce the magnitude of lens aberrations. Among various forms of symmetry, rotational symmetry represents the highest degree of symmetry for lenses. Consequently, electron-optical instruments operating at relatively low electron energies (generally with kinetic energies not exceeding 3 MeV) typically employ lenses having rotational symmetry to focus electron beams. Such lenses are commonly referred to as round lenses. In 1936, the German physicist O. Scherzer established a well-known theorem, commonly referred to as the Scherzer theorem, demonstrating that the chromatic aberration and third-order spherical aberration of a round lens cannot change sign under any circumstances. An important consequence of this theorem is that the chromatic aberration and third-order spherical aberration of an instrument composed solely of rotationally symmetric lenses cannot be corrected. Correction of chromatic aberration and third-order spherical aberration can therefore only be achieved by using elements that do not possess rotational symmetry, or by employing rotationally symmetric reflectors. Although, in theory, alternating electromagnetic fields or space-charge effects may also be used to correct chromatic and third-order spherical aberrations, such approaches have generally not been adopted due to stability limitations.

Aberration correction technology, including aberration correctors, has developed significantly over the past thirty years and has played an important role in improving the spatial resolution of instruments such as transmission electron microscopes, scanning electron microscopes, photoelectron microscopes, and low-energy electron microscopes. Existing aberration correctors may generally be classified into three categories according to their function. A first type corrector corrects only third-order spherical aberration. A second type corrector simultaneously corrects chromatic aberration and third-order spherical aberration. A third type corrector simultaneously corrects third-order and fifth-order spherical aberrations. The third type corrector is generally applicable only to scanning transmission electron microscopes, although in principle it may also be used in scanning electron microscopes. However, existing aberration correction technologies are limited by the configuration of aberration correction reflector apparatus and therefore cannot simultaneously correct chromatic aberration, third-order spherical aberration, and fifth-order spherical aberration. As a result, in transmission electron microscopes, scanning electron microscopes, photoelectron microscopes, and low-energy electron microscopes in which chromatic aberration and third-order spherical aberration have been corrected, the spatial resolution remains limited by fifth-order spherical aberration. Further, in scanning transmission electron microscopes in which third-order and fifth-order spherical aberrations have been corrected, the spatial resolution remains limited by chromatic aberration.

Therefore, the existing technology needs to be improved.

### SUMMARY

In view of the foregoing deficiencies in the prior art, the present application is directed to an aberration correction reflector apparatus, an aberration correction system, and a method thereof. **The** present application is intended to overcome the limitations of existing aberration correction technologies in which, due to constraints associated with conventional aberration correction reflector apparatus, chromatic aberration, third-order spherical aberration, and fifth-order spherical aberration cannot be simultaneously corrected.

**To** achieve the above objectives, the following technical solutions are adopted in the present application.

**In** a first aspect, the present application provides an aberration correction reflector apparatus, which includes a reflector and a transmission electrode group coaxially spaced from one side of the reflector, the transmission electrode group includes four or more transmission electrodes coaxially spaced apart.

**The** reflector includes a reflector body, a first through hole for electrons to pass through is arranged at a center of the reflector body and passes through upper and lower surfaces of the reflector body. **The** reflector also includes a cover disposed on a side of the first through hole away from the transmission electrode group, the cover protrudes toward a direction away from the transmission electrode group.

Each transmission electrode includes a transmission electrode body, and a second through hole for electrons to pass through is arranged at a center of the transmission electrode body and passes through upper and lower surfaces of the transmission electrode body.

In an embodiment, the aberration correction reflector apparatus further includes a connecting tube coaxially disposed on the second through hole on a free end of the transmission electrode away from the reflector.

In an embodiment, a distance between the reflector body and the transmission electrode group is 2-6 mm.

In an embodiment, a distance between two adjacent transmission electrode bodies is 2-6 mm.

In an embodiment, a thickness of the transmission electrode body is 2-6 mm.

In an embodiment, a radius of the first through hole is 2-6 mm, a radius of the second through hole is 3-10 mm, and an inner diameter of the connecting tube is 3-10 mm.

In an embodiment, an inner surface of the cover is a cylindrical, conical, or spherical surface that protrudes toward the direction away from the transmission electrode group.

In an embodiment, the spherical surface has a radius of 5.6 mm.

A second aspect of the present application provides an aberration correction system, which includes a magnetic deflector, a first matching reflector, a second matching reflector, a third matching reflector, and the aberration correction reflector apparatus. The first matching reflector, the magnetic deflector, and the second matching reflector are arranged coaxially in sequence along a direction of an optical path; the third matching reflector is disposed on one side of the magnetic deflector perpendicular to the optical path, and the aberration correction reflector apparatus is disposed on a side of the third matching reflector away from the magnetic deflector.

A third aspect of the present application provides an aberration correction method, which installs the aberration correction system sequentially. The transmission electrode group includes four transmission electrodes coaxially spaced apart, a voltage of the reflector is set to 3.5-5.5 kV, and voltages of each transmission electrode, starting from the reflector, are set to 1.5-17 kV, 14-17.5 kV, 5.5-10 kV, and 5.0-15.0 kV, respectively.

Compared with the prior art, the present application provides the following advantages. A correction system employing the aberration correction reflector apparatus of the present application can simultaneously correct chromatic aberration, third-order spherical aberration, and fifth-order spherical aberration, and may further improve the spatial resolution of an electron-optical system as well as the transmission efficiency of electrons..

### BRIEF DESCRIPTION OF DRAWINGS

FIG. 1 is a structural schematic diagram of an aberration correction reflector apparatus according to Embodiment 1 of the present application.
FIG. 2 is a cross-sectional schematic diagram of the aberration correction reflector apparatus according to Embodiment 1 of the present application.
FIG. 3 is a cross-sectional schematic diagram of the aberration correction reflector apparatus according to Embodiment 2 of the present application.
FIG. 4 is a cross-sectional schematic diagram of the aberration correction reflector apparatus according to Embodiment 3 of the present application.
FIG. 5 is a cross-sectional schematic diagram of the aberration correction reflector apparatus according to Embodiment 4 of the present application.
FIG. 6 is a cross-sectional schematic diagram of the aberration correction reflector apparatus according to Embodiment 5 of the present application.
FIG. 7 is a structural schematic diagram of an aberration correction system according to Embodiment 6 of the present application.
FIG. 8 is a graph showing the change in spatial resolution as a function of half angle according to Embodiment 6 of the present application.

### DETAILED Description of embodimentS

The present application provides an aberration correction reflector apparatus, an aberration correction system, and a method thereof. To make the objectives, technical solutions, and effects of the present application clearer and more explicit, the present application is further described in detail below. It should be understood that the embodiments described herein are merely illustrative and not intended to limit the present application.

Due to constrains of existing aberration correction reflector apparatus, existing aberration correction technologies cannot simultaneously correct chromatic aberration, third-order spherical aberration, and fifth-order spherical aberration. As a result, the spatial resolutions of transmission electron microscopes, scanning electron microscopes, photoelectron microscopes, and low-energy electron microscopes that have corrected chromatic aberration and third-order spherical aberration are limited by fifth-order spherical aberration, while the spatial resolutions of scanning transmission electron microscopes that have corrected third-order and fifth-order spherical aberration are limited by chromatic aberration.

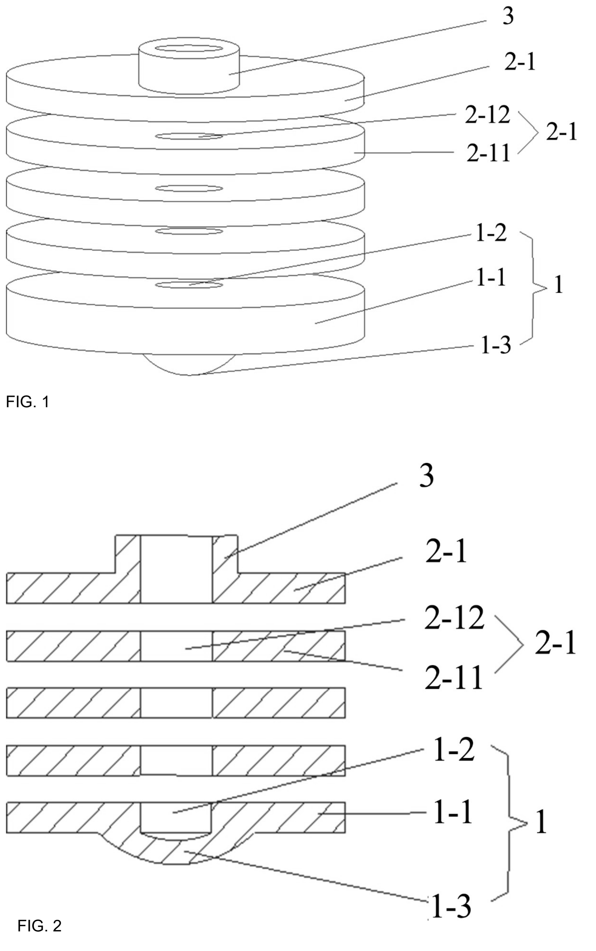

As shown in FIG. 1, the present embodiment provides an aberration correction reflector apparatus, which includes a reflector 1 and a transmission electrode group coaxially spaced from one side of the reflector 1. The transmission electrode group includes four or more transmission electrodes 2-1 coaxially spaced apart.

The reflector 1 includes a reflector body 1-1. A first through hole 1-2 for electrons to pass through is arranged at a center of the reflector body 1-1 and passes through upper and lower surfaces of the reflector body 1-1. The reflector 1 also includes a cover 1-3 that covers a side of the first through hole 1-2 away from the transmission electrode group and the cover 1-3 protrudes toward a direction away from the transmission electrode group.

Each transmission electrode 2-1 includes a transmission electrode body 2-11. A second through hole 2-12 for electrons to pass through is arranged at a center of the transmission electrode body 2-11 and passes through upper and lower surfaces of the transmission electrode body 2-11.

Reflector 1 returns on-axis electrons to their original path, enabling the correction of chromatic aberration, third-order spherical aberration, and fifth-order spherical aberration. The shapes of reflector 1 and each transmission electrode 2-1 affect the spatial distribution of voltages along the electron path, thus determining the overall values of chromatic aberration, third-order spherical aberration, and fifth-order spherical aberration. Once the shapes of reflector 1 and each transmission electrode 2-1 are determined, the spatial distribution of voltages along the electron path can be adjusted by regulating the voltages of reflector 1 and each transmission electrode 2-1. Therefore, the voltages of reflector 1 and each transmission electrode 2-1 can be set on the voltage source as needed to adjust the spatial distribution of voltages along the electron path, thereby achieving simultaneous correction of chromatic aberration, third-order spherical aberration, and fifth-order spherical aberration.

It should be noted that the cover 1-3 can be integrally formed with the reflector body 1-1.

In one embodiment, the aberration correction reflector apparatus further includes a connecting tube 3 that is coaxially disposed on the second through-hole 2-12 on a free end of the transmission electrode 2-1 away from the reflector 1. The connecting tube 3 can be connected to a third matching reflector 7 below a magnetic deflector 4, thereby ensuring that the region inside the tube away from the lens electrode is an isovoltage region.

In some embodiments, a distance between the reflector body and the transmission electrode group is 2-6 mm, which can be any value within the range.

In some embodiments, a distance between two adjacent transmission electrode bodies is 2-6 mm, which can be any value within the range.

In some embodiments, a thickness of the transmission electrode body is 2-6 mm, which can be any value within the range.

In some embodiments, a radius of the first through hole is 2-6 mm, which can be any value within the range.

In some embodiments, a radius of the second through hole is 3-10 mm, which can be any value within the range.

In some embodiments, an inner diameter of the connecting tube is 3-10 mm, which can be any value within the range.

It should be noted that the distance between the reflector 1-1 and the transmission electrode group may be different from the distance between two adjacent transmission electrode bodies 2-11, and the distance between two adjacent transmission electrode bodies 2-11 may also be varied.

The thickness of the transmission electrode body 2-11 may be varied.

The inner diameter mentioned above refer to the diameter of the smallest part of the hole.

In one embodiment, an inner surface of the cover 1-3 is a cylindrical, conical, or spherical surface that protrudes toward the direction away from the transmission electrode group.

It should be noted that the inner surface of the cover 1-3 is not limited to the shape described above, and can also be any other curved surface.

In one embodiment, hole inner walls of the first through hole 1-2 and the second through hole 2-12 are parallel to the hole axis or protrude inward towards a hole center. When the hole inner walls are parallel to the axis, a cylindrical hole is formed; when the hole walls protrude inward towards the center of the hole, the through holes may be configured as double-tapered conical holes having a smaller diameter at a central portion and larger diameters at two ends, or holes having a spherical surface, and a radius of the spherical surface is equal to a half of the thickness of the reflector body.

It should be noted that in the connection between the reflector 1 and each transmission electrode 2-1, as well as in the connection between each transmission electrode 2-1, insulating material is needed due to different voltages. The configuration of connections has no impact on the aberration correction.

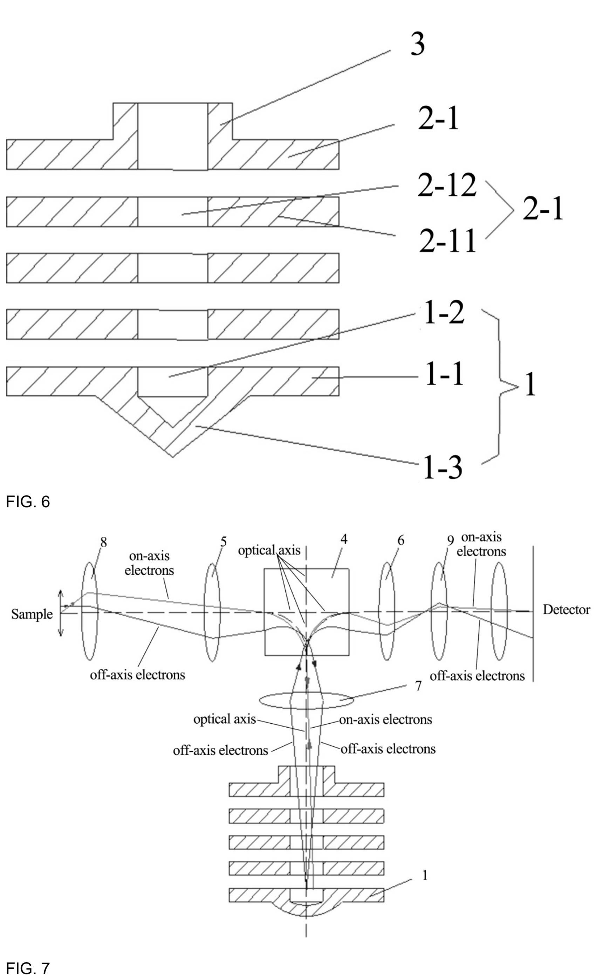

The present application also provides an aberration correction system, as shown in FIG. 7, which includes a magnetic deflector 4, a first matching reflector 5, a second matching reflector 6, a third matching reflector 7, and the aberration correction reflector apparatus mentioned above. The first matching reflector 5, the magnetic deflector 4, and the second matching reflector 6 are arranged coaxially along the direction of the optical path (i.e., optical axis). The third matching reflector 7 is located on one side of the magnetic deflector 4 perpendicular to the optical path, and the aberration correction reflector apparatus is located on a side of the third matching reflector 7 away from the magnetic deflector 4.

The present application also provides an aberration correction method. According to the method, the aberration correction system is installed sequentially. The transmission electrode group includes four transmission electrodes 2-1 coaxially spaced apart. A voltage of the reflector 1 is set to 3.5-5.5 kV, and voltages of the transmission electrodes 2-1, starting from the reflector 1, are set to 1.5-17 kV, 14-17.5 kV, 5.5-10 kV, and 5.0-15.0 kV, respectively. The voltages of the reflector 1 and each transmission electrode 2-1 are adjusted as needed. The voltage of the reflector 1 can be 3.5 kV, 4.5 kV, 5.5 kV, or any value within the range. The voltages of each transmission electrode 2-1 from the reflector 1 can be any value within the range.

In FIG. 1, since the uppermost transmission electrode 2-1 is connected to the connecting tube 3, the voltages remain the same. As shown in FIG. 7, the connecting tube 3 is connected to the third matching reflector 7, so the voltage of the transmission electrode 2-1 with the connecting tube 3 is not arbitrarily adjustable. Therefore, the aberration correction reflector apparatus in FIG. 1 includes four voltage-adjustable parts (the second to fourth transmission electrodes counted from the top, and the reflector). The voltages of these four parts can be used to adjust the values of chromatic aberration, third-order spherical aberration, fifth-order spherical aberration, and defocus. Since the four voltages and the four objective functions (chromatic aberration, third-order spherical aberration, fifth-order spherical aberration, and defocus) are not orthogonal, that is, changing any voltage will cause the values of all four objective functions to change, the solution process requires multiple iterations. The solution process is not the problem to be solved by the present application and will not be discussed in detail here.

The first matching reflector 5 is close to a sample end, the second matching reflector 6 is close to a detector end, an objective lens 8 should be provided between the first matching reflector 5 and the sample, and one or more projection reflectors 9 should be provided between the second matching reflector 6 and the detector.

The principle of the aberration correction system in the present embodiment is shown in FIG. 7. The magnetic deflector 4 separates the electron trajectory incident on the aberration correction reflector apparatus from the electron trajectory reflected by the aberration correction reflector apparatus. Three matching reflectors adjust the electron path to minimize the aberrations of the magnetic deflector and the influence of the aberration correction reflector apparatus on other aberrations. The magnetic deflector 4 itself has a mirror symmetry. The objective lens 8 and the first matching reflector 5 make the on-axis electrons (green lines in the figure) symmetrical about the midpoint of the magnetic deflector 4 when the on-axis electrons first pass through the magnetic deflector 4. At the same time, the objective lens 8 and the first matching reflector 5 make the off-axis electrons (red lines in the figure) anti-symmetrical about the midpoint of the magnetic deflector 4 when the off-axis electrons first pass through the magnetic deflector 4. The third matching reflector 7 and the aberration correction reflector apparatus make the on-axis electrons symmetrical about the turning point when the on-axis electrons pass through the aberration correction reflector apparatus. At the same time, the third matching reflector 7 and the aberration correction reflector apparatus make the off-axis electrons anti-symmetrical about the turning point when the off-axis electrons pass through the aberration correction reflector apparatus. The second matching reflector 6 projects the intermediate image upstream of the first projection reflector 9, which is finally detected by the detector.

It should be noted that the above coaxial setup is not a physical coaxial setup, but rather an electronic optical path coaxial setup.

### Embodiment 1

As shown in FIG. 2, an aberration correction reflector apparatus of the present embodiment includes a reflector 1 and a transmission electrode group coaxially spaced from one side of the reflector 1. The transmission electrode group includes four or more transmission electrodes 2-1 coaxially spaced apart.

The reflector 1 includes a reflector body 1-1, and a first through hole 1-2 for electrons to pass through is arranged at a center of the reflector body 1-1 and passes through upper and lower surfaces of the reflector body 1-1. The reflector 1 also includes a cover 1-3 that covers a side of the first through hole 1-2 away from the transmission electrode group and protrudes toward a direction away from the transmission electrode group.

Each transmission electrode 2-1 includes a transmission electrode body 2-11, and a second through hole 2-12 for electrons to pass through is arranged at a center of the transmission electrode body 2-11 and passes through upper and lower surfaces of the transmission electrode body 2-11.

The aberration correction reflector apparatus also includes a connecting tube 3 coaxially disposed on a second through hole 2-12 on a free end of a transmission electrode 2-1 away from the reflector 1.

In the present embodiment, a distance between the reflector 1-1 and the transmission electrode group is 2.681 mm. The distance refers to an interval between the two, that is, the interval between the side of the reflector 1-1 closest to the transmission electrode group and the side of the transmission electrode group closest to the reflector 1-1.

A distance between two adjacent transmission electrode bodies 2-11 is 2.681 mm.

A thickness of the transmission electrode body 2-11 is 2.681 mm.

A radius of the first through hole 1-2 is 3.805mm, a radius of the second through hole 2-12 is 3.805mm, and an inner diameter of the connecting tube 3 is 3.805mm.

The diameters mentioned above refer to the diameter of the smallest part of the hole.

An inner surface of the cover 1-3 in the present embodiment is a spherical surface with a radius of 5.6 mm, as shown in FIG. 2.

In the present embodiment, the hole inner walls of the first through hole 1-2 and the second through hole 2-12 are parallel to the axis to form cylindrical holes, as shown in FIG. 2.

### Embodiment 2

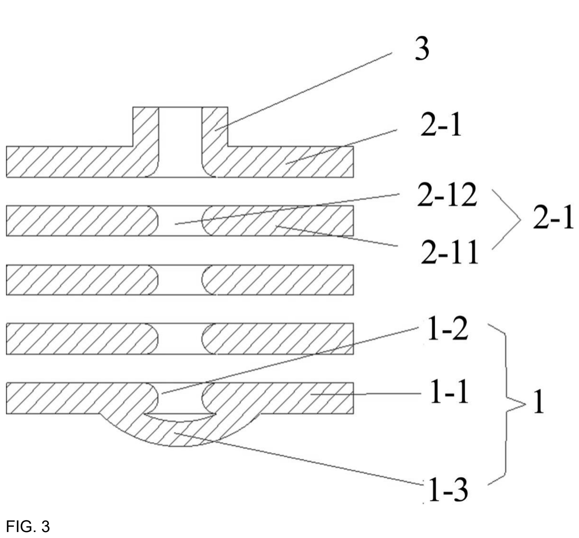

As shown in FIG. 3, unlike in Embodiment 1, the hole inner walls of the first through hole 1-2 and the second through hole 2-12 protrude inward towards the center of the holes to form holes having a spherical surface, and the radius of the spherical surface of the holes is equal to a half of the thickness of the reflector body.

### Embodiment 3

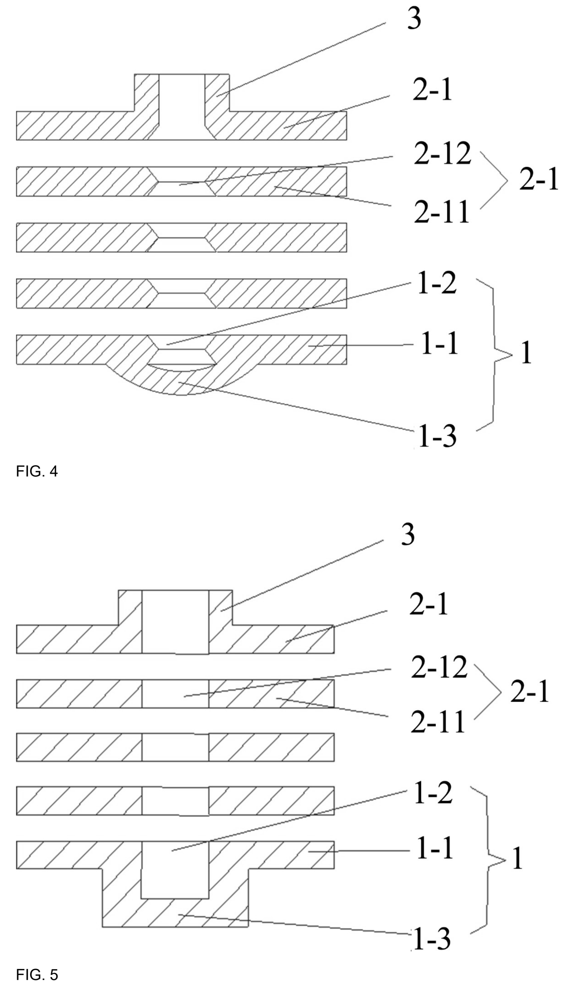

As shown in FIG. 4, unlike in Embodiment 1, the hole inner walls of the first through hole 1-2 and the second through hole 2-12 protrude inward towards the center of the holes to form two double-tapered conical holes having a smaller diameter at a middle portion and larger diameters at both ends.

### Embodiment 4

As shown in FIG. 5, unlike in Embodiment 1, the cover 1-3 in the present embodiment is a cylindrical surface that protrudes in the direction away from the transmission electrode group.

### Embodiment 5

As shown in FIG. 6, unlike in Embodiment 1, the inner surface of the cover 1-3 is a conical surface protruding in the direction away from the transmission electrode group.

### Embodiment 6

The aberration correction reflector apparatus of Embodiment 2 is applied to an aberration correction system, as shown in FIG. 7. The aberration correction system of the present embodiment includes a magnetic deflector 4, a first matching reflector 5, a second matching reflector 6, a third matching reflector 7, and the aberration correction reflector apparatus mentioned above. The first matching reflector 5, the magnetic deflector 4, and the second matching reflector 6 are arranged coaxially in sequence along the direction of the optical path. The third matching reflector 7 is located on one side of the magnetic deflector 4 perpendicular to the optical path, and the aberration correction reflector apparatus is located on a side of the third matching reflector 7 away from the magnetic deflector 4.

The first matching reflector 5 is close to the sample end, the second matching reflector 6 is close to the detector end, an objective lens 8 is provided between the first matching reflector 5 and the sample, and two projection reflectors 9 are provided between the second matching reflector 6 and the detector.

The transmission electrode group in the present embodiment includes four transmission electrodes 2-1 coaxially spaced apart. The voltage of the reflector 1 is set to 3.6801493 kV, and the voltages of the transmission electrodes 2-1, starting from the reflector 1, are set to 16.8303078 kV, 14.0450711 kV, 5.9086491 kV, and 4.9840000 kV, respectively.

In order to increase the range of the objective functions, a distance between the third matching reflector 7 and a bottom surface of the cover 1-3 is often used as a variable in the solution process. Therefore, in the present embodiment, the distance between the third matching reflector 7 and the bottom surface of the cover 1-3 is between 450-600 mm (513 mm in the present embodiment).

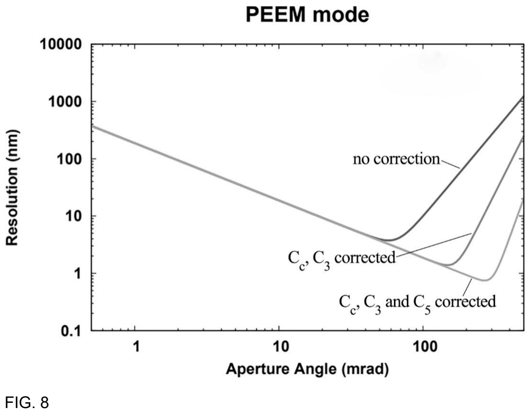

As shown in FIG. 7, the blue line represents the optical axis, the red line represents off-axis electrons, and the green line represents on-axis electrons. The intersection of the green and blue lines is the imaging point, and the plane perpendicular to the blue line is the image plane. The plane perpendicular to the blue line at the intersection of the red and blue lines is the focal plane. Objective lens 8 images the sample at the entrance of the magnetic deflector 4, and the first matching reflector 5 images the focal plane at the midpoint (45°) of the first deflection of the magnetic deflector 4. The magnetic deflector 4 images the sample image at the entrance at the exit of the first deflection. The third matching reflector 7 images the focal plane at the reflection point within the aberration correction reflector apparatus, which is located on the central axis of reflector 1, not far from the concave surface of the reflector (approximately a few millimeters away). The aberration correction reflector apparatus images the sample image at the exit of the first deflection of the magnetic deflector 4 at the entrance of the second deflection of the magnetic deflector 4 (spatially coinciding with the exit of the first deflection of the magnetic deflector 4). Due to symmetry, the third matching reflector 7 images the focal plane at the midpoint (45°) of the second deflection of the magnetic deflector 4. The magnetic deflector 4 images the sample image at the entrance of the second deflection at the exit of the second deflection. The second matching reflector 6 images the sample image at the exit of the second deflection in front of the projection reflector 9, and the projection reflector 9 images the sample image onto the detector, resulting in the effect shown in FIG. 8. As can be seen from FIG. 8, the aberration correction reflector apparatus of the present application improves both spatial resolution (according to the vertical axis, the smaller the number, the higher the spatial resolution) and electron transmittance (according to the horizontal axis, the larger the number, the higher the transmittance), and further simultaneously corrects chromatic aberration, third-order spherical aberration, and fifth-order spherical aberration.

**Other** embodiments of the aberration correction reflector apparatus can also achieve the same effect as the above embodiments, thus demonstrating that the correction system adopting the aberration correction reflector apparatus of the present application can simultaneously correct chromatic aberration, third-order spherical aberration, and fifth-order spherical aberration.

It should be understood that the present application is not limited to the embodiments above. Those skilled in the art can make improvements or modifications as described above, and all such improvements and modifications should fall within the protection scope of the appended claims.

## Claims

1. A aberration correction reflector apparatus, comprising a reflector (1) and a transmission electrode group coaxially spaced from one side of the reflector, wherein the transmission electrode group comprises four or more transmission electrodes (2-1) coaxially spaced apart;
the reflector (1) comprises a reflector body (1-1), a first through hole (1-2) for electrons to pass through is arranged at a center of the reflector body (1-1) and passes through upper and lower surfaces of the reflector body (1-1), the reflector (1) further comprises a cover (1-3) disposed on a side of the first through hole (1-2) away from the transmission electrode group, the cover (1-3) protrudes toward a direction away from the transmission electrode group,
each transmission electrode (2-1) in the transmission electrode group comprises a transmission electrode body (2-11), and a second through hole (2-12) for electrons to pass through is arranged at a center of the transmission electrode body (2-11) and passes through upper and lower surfaces of the transmission electrode body (2-11).

2. The aberration correction reflector apparatus according to claim 1, wherein the aberration correction reflector apparatus further comprises a connecting tube (3) coaxially disposed on the second through hole (2-12) on a free end of the transmission electrode (2-1) away from the reflector (1).

3. The aberration correction reflector apparatus according to claim 1, wherein a distance between the reflector body (1-1) and the transmission electrode group is 2-6 mm.

4. The aberration correction reflector apparatus according to claim 1, wherein a distance between two adjacent transmission electrode bodies (2-11) is 2-6 mm.

5. The aberration correction reflector apparatus according to claim 1, wherein a thickness of the transmission electrode body (2-11) is 2-6 mm.

6. The aberration correction reflector apparatus according to claim 2, wherein a radius of the first through hole (1-2) is 2-6 mm, a radius of the second through hole (2-12) is 3-10 mm, and an inner diameter of the connecting tube (3) is 3-10 mm.

7. The aberration correction reflector apparatus according to claim 1, wherein an inner surface of the cover (1-3) is a cylindrical, conical, or spherical surface that protrudes toward the direction away from the transmission electrode group.

8. The aberration correction reflector apparatus according to claim 1, wherein a hole inner walls of the first through hole (1-2) and the second through hole (2-12) are parallel to a hole axis or protrude inward toward a hole center.

9. An aberration correction system, comprising a magnetic deflector (4), a first matching reflector (5), a second matching reflector (6), a third matching reflector (7), and the aberration correction reflector apparatus according to any one of claims 1-8, wherein the first matching reflector (5), the magnetic deflector (4), and the second matching reflector (6) are arranged coaxially in sequence along a direction of an optical path; the third matching reflector (7) is disposed on one side of the magnetic deflector (4) perpendicular to the optical path, and the aberration correction reflector apparatus is disposed on a side of the third matching reflector (7) away from the magnetic deflector (4).

10. A method for aberration correction, comprising installing the aberration correction system according to claim 9 sequentially, wherein the transmission electrode group comprises four transmission electrodes (2-1) coaxially spaced apart, a voltage of the reflector (1) is set to 3.5-5.5 kV, and voltages of each transmission electrode (2-1), starting from the reflector (1), are set to 1.5-17 kV, 14-17.5 kV, 5.5-10 kV, and 5.0-15.0 kV, respectively.
